(19) Europäisches Patentamt / European Patent Office / Office européen des brevets

(11) **EP 3 870 984 B1**

(12) **FASCICULE DE BREVET EUROPEEN**

(45) Date de publication et mention de la délivrance du brevet:
**08.06.2022 Bulletin 2022/23**

(21) Numéro de dépôt: **19794599.1**

(22) Date de dépôt: **18.09.2019**

(51) Classification Internationale des Brevets (IPC):
**G01R 31/3835** (2019.01)

(52) Classification Coopérative des Brevets (CPC):
**G01R 31/3835;** G01R 31/367; Y02T 10/70

(86) Numéro de dépôt international:
**PCT/FR2019/052170**

(87) Numéro de publication internationale:
**WO 2020/084210 (30.04.2020 Gazette 2020/18)**

(54) **PROCEDE D'ESTIMATION DE LA TENSION A CIRCUIT OUVERT D'UN ACCUMULATEUR ELECTROCHIMIQUE DE SYSTEME DE BATTERIE**

VERFAHREN ZUR SCHÄTZUNG DER LEERLAUFSPANNUNG EINES ELEKTROCHEMISCHEN AKKUMULATORS EINES BATTERIESYSTEMS

METHOD FOR ESTIMATING THE OPEN-CIRCUIT VOLTAGE OF AN ELECTROCHEMICAL ACCUMULATOR OF A BATTERY SYSTEM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **23.10.2018 FR 1859764**

(43) Date de publication de la demande:
**01.09.2021 Bulletin 2021/35**

(73) Titulaire: **PSA Automobiles SA**
**78300 Poissy (FR)**

(72) Inventeurs:
• **BAGHDADI, Issam**
**78600 Le Mesnil Le Roi (FR)**
• **CHAABANE, Fedi**
**75014 Paris 14 (FR)**

(56) Documents cités:
**WO-A2-2008/053410**

EP 3 870 984 B1

## Description

Le domaine de l'invention concerne un procédé d'estimation d'un paramètre de tension à circuit ouvert d'une batterie électrochimique, ainsi qu'une unité de commande comportant des moyens de mettre en œuvre ledit procédé.

Dans l'industrie automobile, les véhicules hybrides et véhicules électriques embarquent des systèmes de batterie de puissance munis d'accumulateurs électrochimiques (appelés également cellules) destinés à alimenter les machines motrices électriques du véhicule. Ces systèmes ont aujourd'hui un rôle essentiel pour améliorer les performances énergétiques du véhicule en termes de réduction de la consommation de carburant, d'autonomie de roulage électrique et de puissance de motorisation. Par ailleurs, de nombreuses fonctions de motorisation du groupe motopropulseur dépendent des valeurs des indicateurs d'états du système de batterie, tels les niveaux d'état de charge et d'état de santé du système de batteries désignés respectivement par les acronymes anglais SOC pour « State of Charge » et SOH pour « State of Health ». Par exemple, les décisions de démarrage d'un moteur thermique, le choix entre un mode de roulage hybride ou tout électrique, ou encore des fonctions de navigation de planification de parcours reposent bien souvent sur le niveau d'état de charge du système de batterie. La précision et la mise à jour des indicateurs d'état sont donc cruciales pour le fonctionnement et l'agrément de conduite du véhicule. L'unité de commande du système de batterie, couramment appelée par l'acronyme BMS pour « Battery management System » en anglais, a pour tâche d'estimer en temps réels ces indicateurs d'état.

Parmi ces indicateurs la courbe de tension à circuit ouvert, appelée également par l'acronyme anglais OCV « Open Circuit Voltage », est d'une grande importance car nombre de caractéristiques électriques sont déduites par calcul à partir de sa valeur. Or, comme cela est bien connu, la tension OCV doit être mesurée à l'équilibre thermodynamique d'un accumulateur électrique. Une sollicitation électrique d'un accumulateur (en charge ou décharge) perturbe son équilibre et crée des gradients de concentrations au sein de la matière active. Puis, en relaxation, l'accumulateur tend naturellement à éliminer ces gradients de concentration par l'intermédiaire de réactions d'oxydoréduction. On définit la phase de relaxation comme étant une situation où le courant traversant les bornes de la batterie est nul ou de très faible valeur. Cependant, cet équilibre n'est atteint qu'après une durée assez longue, souvent supérieure à une heure. Les usages automobiles réduisent les opportunités d'occurrence d'une telle durée et empêchent une estimation et mise à jour en temps réel durant le roulage. De plus, les futures applications dites « intelligentes » des systèmes de batterie conçus pour intervenir dans la gestion des réseaux électriques domestiques tendent à planifier et distribuer temporellement les sollicitations électriques ce qui par conséquent réduira également les durées de relaxation.

Pour résoudre ces problèmes, on connait par exemple le document brevet FR3044773A1 décrivant un procédé d'évaluation de l'état de santé d'une batterie électrochimique reposant sur le principe de linéarité entre l'état de santé et la tension à circuit ouvert d'une batterie. Le document WO02091007A1 décrit un procédé de détermination de l'état de charge d'une batterie en mesurant la courbe de tension à circuit ouvert. Un usage embarqué de cette méthode pour le contrôle d'un système de batterie reste problématique pour les véhicules car celle-ci requière un temps de relaxation supérieur à plusieurs dizaines de minutes pour obtenir des résultats d'une précision acceptable. Or, les cycles de roulage des véhicules hybrides et électriques présentent rarement de telles opportunités. On connait également le document WO2008053410A2 décrivant une méthode consistant à estimer l'OCV avec un modèle empirique selon une équation dont les paramètres sont déterminés par régression linéaire. La durée nécessaire de la phase de relaxation est d'environ 20 à 30 minutes pour estimer correctement l'OCV. Des méthodes adaptatives permettent de réduire cette durée, mais nécessitent en contrepartie d'utiliser un algorithme complexe et des ressources de calcul importantes.

Il existe donc un besoin de palier les problèmes précités. Un objectif de l'invention est de proposer une méthode d'estimation de la courbe de tension à circuit ouvert requérant une phase de relaxation de faible durée et des ressources de calcul peu exigeantes afin de permettre un usage embarqué pour obtenir une estimation des indicateurs d'état en temps réel.

Plus précisément, l'invention concerne un procédé de détermination d'un paramètre de tension à circuit ouvert d'une batterie électrochimique d'un système de batterie, le procédé étant exécuté par une unité de commande du système durant une phase de relaxation de la batterie et comportant les étapes suivantes :

- la mesure en continu d'un signal de tension, Uacc(t), aux bornes de la batterie en relaxation en fonction du temps écoulé à partir d'un premier instant de début de la phase de relaxation,

- l'estimation du paramètre de tension à circuit ouvert dépendant dudit signal de tension mesuré,
  ledit procédé étant caractérisé en ce qu'il comporte en outre :

  - le calcul en continu durant la relaxation de la batterie d'un signal logarithmique de la tension dépendant dudit signal de tension Uacc(t) en fonction de la valeur sous forme logarithmique du temps écoulé à partir du premier instant,

- la vérification si le signal logarithmique comporte un point d'inflexion,

- et, en cas de détection d'au moins un point d'inflexion à un deuxième instant, l'estimation consiste à calculer le paramètre de tension à circuit ouvert symétriquement par rapport au point d'inflexion en fonction au moins de la valeur du signal logarithmique au deuxième instant.

Selon une première variante, le signal logarithmique est une première représentation f1 dudit signal de tension Uacc(t) en fonction de la valeur du temps sous forme logarithmique, où :

[Math 1]

$$f1: \log(t) \to Uacc(t)$$

Selon une deuxième variante, le signal logarithmique est une deuxième représentation f2 dudit signal de tension Uacc(t) sous une première forme logarithmique en fonction de la valeur du temps sous forme logarithmique, où :

[Math 2]

$$f2: \log(t) \to \log(Uacc(t))$$

Selon une troisième variante, le signal logarithmique est une troisième représentation f3 dudit signal de tension Uacc(t) sous une deuxième forme logarithmique en fonction de la valeur du temps sous forme logarithmique, où :

[Math 3]

$$f3: \log(t) \to \log(\log(Uacc(t)))$$

Selon une première variante de l'étape d'estimation, l'estimation comporte les étapes suivantes :

- une étape de calcul d'un écart entre la valeur du point d'inflexion du signal logarithmique au deuxième instant et la valeur du signal logarithmique au premier instant,

- une étape de calcul du paramètre de tension à circuit ouvert symétriquement par rapport au point d'inflexion du signal logarithmique au deuxième instant en fonction dudit écart et de la valeur du point d'inflexion.

Selon une deuxième variante de l'étape d'estimation, l'estimation comporte les étapes suivantes :

- une étape de calcul d'une modélisation logarithmique du signal de tension pour des instants postérieurs au deuxième instant du point d'inflexion en fonction du signal logarithmique symétriquement par rapport au point d'inflexion,

- une étape de calcul du paramètre de tension à circuit ouvert en fonction de la valeur de ladite modélisation à un instant recherché postérieur au deuxième instant.

Selon une variante, le calcul de la modélisation logarithmique consiste à ajuster les paramètres d'une fonction de modélisation à partir au moins des valeurs du signal logarithmique mesurées jusqu'au deuxième instant.

Plus précisément, la fonction de modélisation est une fonction g selon l'une quelconque des relations suivantes :

[Math 4]

$$g: x \to a * \tanh(b * x),$$

ou

[Math 5]

$$g : x \rightarrow a * \mathrm{arcsinh}(b * x),$$

ou

[Math 6]

$$g : x \rightarrow a * sigmf(b * x) - 0{,}5,$$

Où a et b sont des paramètres ajustés.

L'invention prévoit également une unité de commande d'un système de batterie comportant une batterie électrochimique, ladite unité comportant des moyens de mettre en œuvre le procédé selon l'un quelconque des modes de réalisation précédent.

L'invention prévoit également un véhicule automobile comprenant un système de batterie comportant ladite unité de commande.

L'invention concerne également un produit programme-ordinateur comprenant des instructions qui, lorsque le programme est exécuté par une unité de commande du système de batterie, conduisent celui-ci à mettre en œuvre l'un quelconque des modes de réalisation du procédé de détermination de la tension à circuit ouvert conformément à l'invention.

Grâce à l'invention, la tension à circuit ouvert OCV est estimée en seulement quelques dizaines de secondes au lieu des quelques heures nécessaires par l'observation seule de la courbe de tension en relaxation. Par ailleurs, le procédé est exécutable sans recours à des ressources de calcul importantes. Le procédé a été validé après charge et décharge à différents états de charge et états de santé d'une batterie et même de différentes chimies. De plus, il a été observé que le procédé de détermination de l'OCV n'est pas sensible à la température. En effet, la température reste constante durant la phase de détection du point d'inflexion. Tous ces avantages rendent le procédé particulièrement avantageux pour des applications embarquées, la gestion en temps réelle des indicateurs d'états et une amélioration de la précision de ces indicateurs.

D'autres caractéristiques et avantages de la présente invention apparaitront plus clairement à la lecture de la description détaillée qui suit comprenant des modes de réalisation de l'invention donnés à titre d'exemples nullement limitatifs et illustrés par les dessins annexés, dans lesquels :

- [Fig. 1] représente un système de batterie comportant une batterie électrochimique et une unité de commande configurée pour mettre en œuvre le procédé selon l'invention.

- [Fig. 2] est un graphique représentant en partie supérieure la tension mesurée aux bornes de la batterie en relaxation durant l'exécution du procédé selon l'invention et en partie inférieure le signal logarithmique de la tension permettant de calculer l'OCV symétriquement par rapport à un point d'inflexion selon un premier mode de réalisation du procédé.

- [Fig. 3a] est un organigramme représentant un algorithme du premier mode de réalisation du procédé de détermination de la tension à circuit ouvert selon l'invention.

- [Fig. 3b] est un organigramme représentant un algorithme d'un deuxième mode de réalisation du procédé de détermination selon l'invention par une méthode d'ajustement paramétrique d'une fonction de modélisation du signal logarithmique.

- [Fig. 4] est un graphique illustrant le deuxième mode de réalisation du procédé de détermination à partir de la méthode d'ajustement paramétrique.

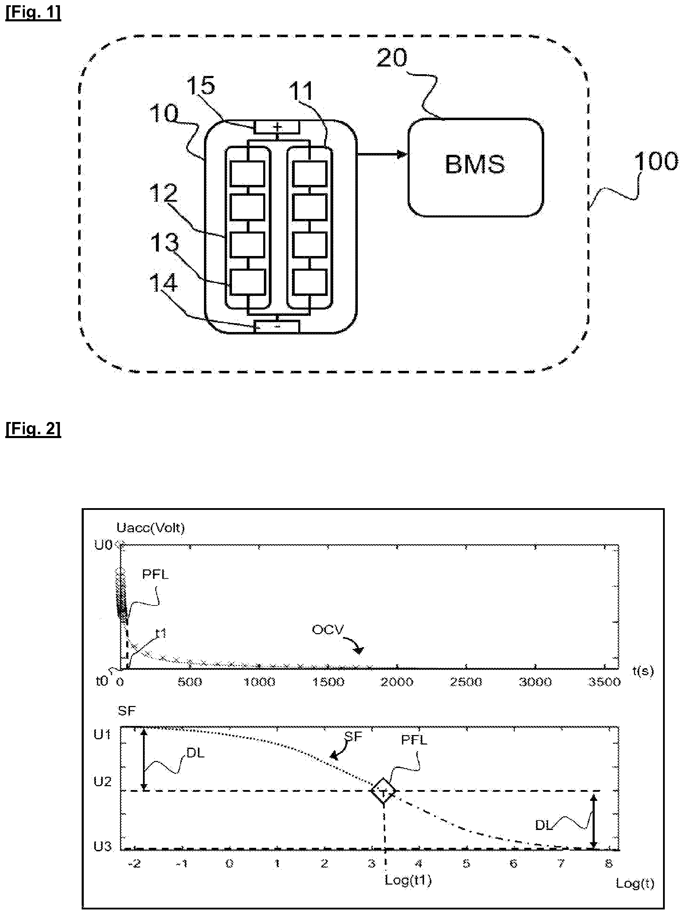

L'invention concerne un procédé de détermination de la tension à circuit ouvert d'une batterie électrochimique d'un système de batterie, souvent désigné également l'expression module de batterie ou par le terme anglais « pack ». La figure 1 illustre schématiquement un système de batterie 100 destiné à équiper un véhicule automobile électrique comprenant une pluralité d'accumulateurs électrochimiques. Le système de batterie 100 comporte un module d'accumulateurs électrochimiques 10 et une unité de commande 20 pour la gestion du module 10. Typiquement, dans le cas d'une application de groupe motopropulseur automobile hybride électrique ou entièrement électrique, un système de batterie des machines motrices peut être équipé d'une pluralité de modules permettant le stockage et la restitution d'énergie électrique. Le module 10 peut être adressé individuellement par le système de batterie 100. Le module 10 comporte deux bornes de connexion 15, 14 pouvant fournir une tension électrique et un courant électrique déterminés en fonction du nombre de cellules électriques 13 assemblées en série et/ou en parallèle. Par exemple, le module 10 de cellules unitaires 13 comporte deux rangées 11, 12 ou plus montées en parallèle, chaque rangée étant constituée de cellules électriques unitaires 13 connectées en série.

Le système de batterie électrochimique 100 est de technologie de type Lithium, Li-ion, ou autres. Il est bien entendu que le système de batterie 100 et le procédé selon l'invention s'applique à d'autres applications, plus générale-lement à tout dispositif électrique ou électronique requérant une alimentation électrique constituée d'accumulateurs électrochimiques. Dispositifs portables, ordinateurs, installation d'alimentation électriques, satellites et bancs de test et de calibration sont des exemples d'une liste non exhaustive pour lesquels l'invention peut s'appliquer.

Le procédé de détermination de la tension à circuit ouvert est exécutable pour déterminer le paramètre de tension à circuit ouvert OCV de chacun des modules de batterie adressable individuellement d'un système de batterie via des bornes de connexion électrique dudit module, ou pour déterminer le paramètre OCV d'un système dans son ensemble, ou bien encore d'une cellule unitaire lorsque celle-ci est adressable individuellement.

L'unité de commande 20 est un calculateur électronique à circuits intégrés muni d'un processeur et de mémoires électroniques pour exécuter le procédé de détermination du paramètre de tension à circuit ouvert OCV d'un module de batterie électrochimique. L'unité de commande 20 comporte des moyens de mesure de la tension et du courant du module 10 (capteurs de tension et de courant), des moyens de détection d'une phase de relaxation du module de batterie, plus précisément la détection d'un courant nul aux bornes du module, et des moyens de calcul pour opérer les étapes de calcul du procédé qui seront décrites ci-après. L'unité de commande comporte des moyens pour enregistrer les indicateurs d'état d'un module, tels l'indicateur OCV, SOC et SOH par exemple à des fins de gestion du système de batterie au cours de la vie d'utilisation du véhicule. On ajoutera que selon l'application l'unité de commande est un système de gestion de la batterie embarqué (par exemple BMS d'un véhicule automobile) ou tout type de dispositif de contrôle de la batterie (ordinateur, application de gestion distante, ou ordinateur de banc de test).

Après une sollicitation électrique d'un accumulateur électrochimique, la tension aux bornes de l'accumulateur se relaxe à courant nul et tend vers un équilibre thermodynamique caractérisé par la tension à circuit ouvert. La détermination du paramètre de tension à circuit ouvert selon l'invention repose sur le principe de symétrie par rapport à un point d'inflexion du signal de tension représenté sous une forme logarithmique lors de la transition de phase chimique depuis l'état sollicité à l'état de relaxation de l'accumulateur. Lors d'une phase de relaxation d'une batterie, l'évolution des volumes des réactifs lors de la transition de phase suit au court du temps une courbe, symétrique par rapport à un point d'inflexion, de forme sigmoïdale avec des vitesses d'évolution faible en début et fin de transition, et rapide dans une période intermédiaire. Or, le signal logarithmique du signal de tension est proportionnel à l'évolution des volumes des réactifs. Le point d'inflexion permet ainsi d'estimer la valeur de la tension à circuit ouvert par reconstruction symétrique. De plus, grâce à l'invention, il n'est nécessaire de mesurer le signal de tension que seulement durant les premières dizaines de secondes de la phase de relaxation pour détecter ce point d'inflexion et ainsi estimer le paramètre de tension à circuit ouvert OCV par symétrie. Ce temps est très inférieur par rapport aux méthodes connues de calcul requérant généralement des durées de plusieurs dizaines de minutes ou plus.

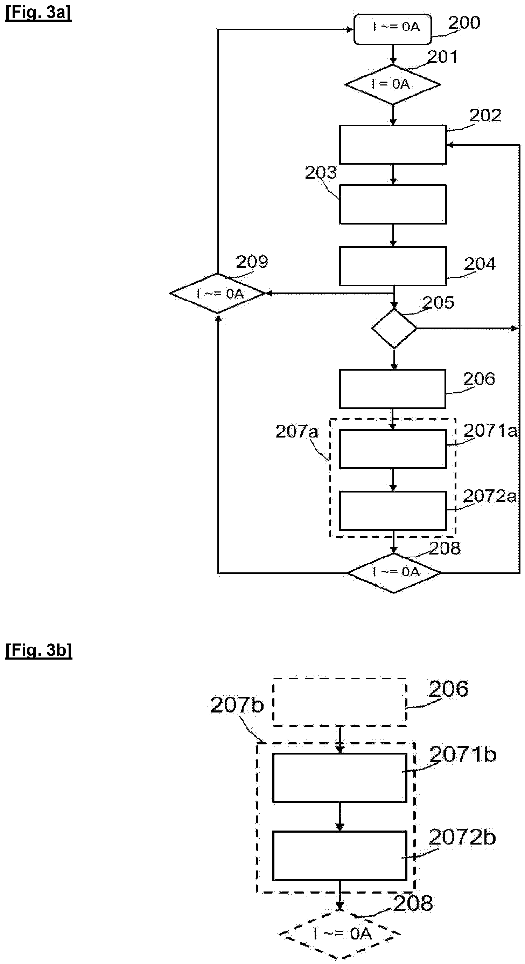

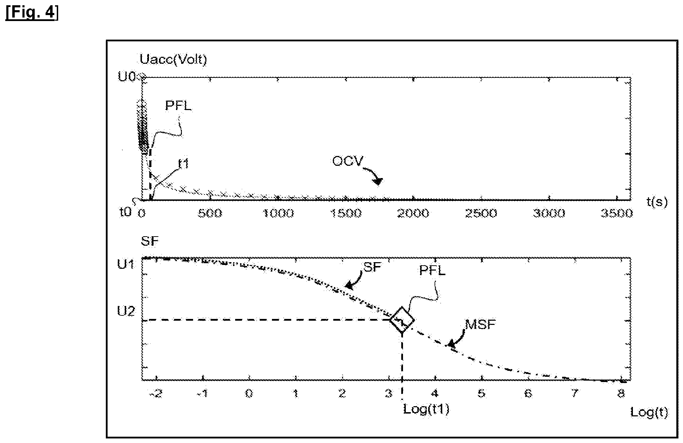

Dans la suite de la description, l'invention sera décrite par une application sur un accumulateur électrochimique unitaire. Un premier mode de réalisation du procédé de détermination de la tension à circuit ouvert est illustré graphiquement par la figure 2. La figure 3a décrit l'algorithme du premier mode de réalisation du procédé. Un algorithme d'un deuxième mode de réalisation est décrit en figure 3b, où seules les étapes se différenciant du procédé de la figure 3a sont représentées. Ce deuxième mode de réalisation est ensuite illustré graphiquement par la figure 4.

Plus précisément, en partie supérieure de la figure 2, le graphique représente un signal de tension Uacc en unité de Volts mesuré aux bornes de l'accumulateur électrochimique lors d'une phase de relaxation en fonction du temps écoulé t, en unité de secondes, à partir d'un instant t0 du début de la phase de relaxation à la suite d'une opération de recharge de l'accumulateur ou une opération de décharge de l'accumulateur. Les valeurs de tension mesurées sont représentées par des cercles. Les points indiqués en forme de croix représentent l'évolution attendue de la courbe de relaxation de la tension Uacc. U0 est la valeur de la tension Uacc au début de la phase de relaxation. Puis, après une durée de relaxation supérieure à environ 1000s, l'accumulateur électrochimique atteint l'équilibre thermodynamique à partir duquel la tension Uacc tend à se stabiliser à la valeur de tension à circuit ouvert OCV.

En partie inférieure, le graphique représente le signal logarithmique SF du signal de tension Uacc(t), lequel signal de tension a été mesuré par l'unité de commande de l'accumulateur. Le signal logarithmique SF dépend dudit signal de tension Uacc(t) en fonction de la valeur sous forme logarithmique du temps écoulé à partir de l'instant t0. Le signal logarithmique SF présente un point d'inflexion PFL à l'instant t1. Ce point d'inflexion est exploité judicieusement par l'unité de commande pour estimer la tension à circuit ouvert OCV par symétrie.

La figure 3a décrit un algorithme du premier mode de réalisation du procédé. A une première étape 200, l'unité de commande de l'accumulateur pilote une opération de recharge ou décharge électrique. Le courant est non nul aux bornes de l'accumulateur. Tant que le courant est non nul, le procédé reste à l'étape 200.

A l'étape 201, lorsqu'un courant nul aux bornes de l'accumulateur est détecté, l'unité de commande pilote une étape 202 de mesure en continu au moyen d'un capteur de tension à partir de l'instant t0 d'un signal de tension Uacc(t) pour des instants supérieurs à t0. Les valeurs du signal de tension Uacc(t) sont enregistrées en mémoire de l'unité de commande. Le signal Uacc(t) est représenté sur la figure 2 en partie supérieure.

Ensuite, à une étape 203, l'unité de commande calcule en continu durant la relaxation de l'accumulateur un signal logarithmique SF de la tension dépendant dudit signal de tension Uacc(t) en fonction de la valeur sous forme logarithmique du temps écoulé à partir de l'instant t0. Les valeurs du signal logarithmique SF sont représentées schématiquement sur la partie inférieure de la figure 2 par un trait pointillé régulier. Le signal logarithmique SF se caractérise par une courbe en forme de S du fait des asymptotes à l'infini et de la symétrie par rapport à un point d'inflexion. Le signal logarithmique SF est caractéristique de la transition de phase de la réaction électrochimique durant la relaxation de l'accumulateur. L'objectif du procédé est de détecter ce point d'inflexion pour estimer le paramètre de la tension OCV.

A titre d'exemple, au moins trois variantes du signal logarithmique SF sont calculables par l'unité de commande. Selon une première représentation f1 du signal de tension Uacc(t), le signal logarithmique SF représente le signal de tension Uacc(t) en fonction de la valeur du temps t sous forme logarithmique, où

[Math 7]

$$f1 : \log(t) \rightarrow Uacc(t)$$

Selon une autre variante, le signal logarithmique SF est une deuxième représentation f2 dudit signal de tension Uacc(t) sous une première forme logarithmique en fonction de la valeur du temps t sous forme logarithmique, où

[Math 8]

$$f2 : \log(t) \rightarrow \log(Uacc(t))$$

Ou encore, selon une autre variante, le signal logarithmique SF est une troisième représentation f3 dudit signal de tension Uacc(t) sous une deuxième forme logarithmique en fonction de la valeur du temps t sous forme logarithmique, où

[Math 9]

$$f3 : \log(t) \rightarrow \log\big(\log\big(Uacc(t)\big)\big)$$

La fonction f3 est préférentiellement choisie lors de l'étape de calcul 203 du fait que le signal logarithmique SF du signal de tension est proportionnel au volume du réactif en cours de transformation de phase lors de la relaxation.

De plus, pour vérifier la présence d'un point d'inflexion sur la courbe du signal logarithmique SF, l'unité de commande calcule à l'étape 203 le signal de dérivée seconde du signal logarithmique SF. Il est bien entendu que d'autres variantes calculatoires de détection d'un point d'inflexion sont envisageables.

Ensuite, à une étape 204 du procédé, l'unité de commande enregistre dans une mémoire les valeurs du signal de tension Uacc(t) mesurées, les valeurs du signal logarithmique SF du signal de tension et les valeurs du signal de dérivée seconde le cas échéant.

A une étape 205, l'unité de commande vérifie en continu si le signal logarithmique SF présente un point d'inflexion. La détection est opérée en vérifiant le signe du signal de dérivée seconde. En cas de changement de signe, l'unité de commande détecte un point d'inflexion. Tant qu'aucun point d'inflexion est détecté, l'unité de commande opère en continu les étapes successives 202, 203, 204. De plus, lorsque l'unité de commande détecte à l'étape 209 un courant non nul, le procédé se termine et retourne à l'étape 200.

En référence à la figure 2, à l'instant t1, l'unité de commande détecte un point d'inflexion PFL. L'unité de commande enregistre en mémoire à l'étape 206 les valeurs du point d'inflexion détecté. Le procédé comporte ensuite une étape d'estimation 207a qui consiste à calculer le paramètre de tension à circuit ouvert OCV symétriquement par rapport au point d'inflexion PFL en fonction de la valeur U2 du signal logarithmique SF au deuxième instant t1. A cet effet, l'unité de commande exécute les sous-étapes suivantes de calcul 2071a d'un écart DL entre la valeur U2 du point d'inflexion PFL du signal logarithmique SF et la valeur U1 du signal logarithmique SF à l'instant t0 au déclenchement de la phase de relaxation, puis une étape de calcul 2072a du paramètre de tension à circuit ouvert OCV symétriquement par rapport au point d'inflexion PFL du signal logarithmique SF en fonction dudit écart DL et de la valeur U2 du point d'inflexion PFL. La valeur U3 indiquée sur la figure 2 indique la valeur du signal logarithmique SF à un temps infini calculée en fonction de la valeur DL symétriquement par rapport à la valeur U2.

En considérant l'hypothèse que le signal logarithmique SF correspond à la fonction f3, l'écart DL et la valeur de la tension à circuit ouvert OCV sont calculés selon les relations suivantes :

[Math 10]

$$DL = \log\big(\log(Uacc(t1))\big) - \log\big(\log(Uacc(t0))\big)$$

[Math 11]

$$OCV = \exp(\exp\big(\log(\log(Uacc(t1))) + DL\big))$$

Dans l'hypothèse que le signal logarithmique SF correspond à la fonction f2, l'écart DL et la valeur de la tension à circuit ouvert OCV sont calculés selon les relations suivantes :

[Math 12]

$$DL = \log\big(Uacc(t1)\big) - \log(Uacc(t0))$$

[Math 13]

$$OCV = \exp\big(\log((Uacc(t1)) + DL\big)$$

Et, dans l'hypothèse que le signal logarithmique SF correspond à la fonction f1, l'écart DL et la valeur de la tension à circuit ouvert OCV sont calculés selon les relations suivantes :

[Math 14]

$$DL = Uacc(t1) - Uacc(t0)$$

[Math 15]

$$OCV = Uacc(t1) + DL$$

Les valeurs de l'écart DL et de la tension à circuit ouvert OCV calculée à partir du point d'inflexion PFL sont enregistrées en mémoire de l'unité de commande et exploitables par celle-ci pour exécuter des calculs d'indicateurs d'état de l'accumulateur électrochimique, tels l'état de charge SOC et l'état de vieillissement SOH.

Lorsque le courant aux bornes de l'accumulateur électrochimique est non nul, alors l'unité de commande pilote le procédé à l'étape 209 qui renvoie le procédé à l'étape initiale 200. Si le courant aux bornes de l'accumulateur est nul, l'unité de commande pilote le procédé à l'étape 202 pour poursuivre la mesure du signal de tension Uacc(t), le calcul 203 du signal logarithmique SF et la vérification 204 de la présence de points d'inflexion supplémentaires, jusqu'à atteindre une valeur de tension OCV si la durée de relaxation est suffisante pour atteindre l'équilibre thermodynamique de l'accumulateur. Dans ce cas-ci, la valeur du paramètre de tension OCV est mise à jour en fonction de la valeur mesurée.

En figure 3b et figure 4, le deuxième mode de réalisation du procédé est décrit. Le deuxième mode de réalisation a pour avantage de permettre le calcul par modélisation d'une valeur de tension à circuit ouvert pour des durées de relaxation paramétrables. Les durées de relaxation paramétrables sont comprises entre l'instant du point d'inflexion et un instant de calcul de l'OCV à l'infini.

Par soucis de concision, seules les étapes se différenciant du premier mode de réalisation sont représentées. Les étapes du deuxième mode de réalisation 200 à 206, 208 et 209 sont identiques au premier mode de réalisation. L'étape d'estimation 207b succède à l'étape 206 et précède l'étape 208. L'estimation 207b se différencie de l'étape 207a du fait que la valeur de la tension à circuit ouvert OCV est calculée par une méthode d'ajustement des paramètres d'une fonction de modélisation en forme de S à partir au moins des valeurs mesurées du signal de tension Uacc(t) et du signal logarithmique SF. Il est bien entendu que toute méthode de reconstruction d'une fonction de modélisation à partir des valeurs mesurées du signal de tension est applicable au deuxième mode de réalisation, par exemple par calcul d'approximation de paramètres.

Plus précisément, l'étape 207b comporte une étape de calcul 2071b d'une modélisation logarithmique MSF, représentée en figure 4 par le trait pointillé irrégulier, du signal de tension Uacc(t) pour des instants postérieurs au deuxième instant t1, en fonction du signal logarithmique SF symétriquement par rapport au point d'inflexion PFL, puis une étape de calcul 2072b du paramètre de tension à circuit ouvert OCV en fonction de la valeur de ladite modélisation MSF à un instant recherché postérieur au deuxième instant t1.

Préférentiellement l'étape de calcul 2071b consiste à ajuster les paramètres d'une fonction de modélisation en forme de S à partir au moins des valeurs du signal logarithmique SF, par exemple une fonction de modélisation désignée g, de type sigmoïde, tangente hyperbolique ou arcsinus hyperbolique. En effet, lors de la relaxation, la réaction principale est gouvernée par la transformation des phases dans la matière active, réaction dite de germination autocatalytique, caractérisée par une vitesse sigmoïdale. La sigmoïde est équivalente à une fonction de tangente hyperbolique que l'unité de commande a pour objectif de modéliser au moyen du procédé afin d'estimer la tension OCV et les paramètres caractérisant la vitesse sigmoïdale de la réaction autocatalytique.

L'unité de commande applique une méthode d'ajustement par optimisation paramétrique en diminuant l'erreur quadratique entre le signal logarithmique mesuré SF et la fonction de modélisation g. A titre d'exemples non limitatifs, la méthode d'ajustement exploite les algorithmes d'optimisation paramétrique connus de l'homme du métier, tels la méthode simplex laquelle est citée dans la littérature par la référence « Lagarias, J. C., J. A. Reeds, M. H. Wright, and P. E. Wright, "Convergence Properties of the Nelder-Mead Simplex Method in Low Dimensions." SIAM Journal of Optimization. Vol. 9, Number 1, 1998, pp. 112-147», ou la méthode des moindres carrés, par exemple méthode citée par la référence « Marquardt, D. "An Algorithm for Least-squares Estimation of Nonlinear Parameters." SIAM Journal Applied Mathematics, Vol. 11, 1963, pp. 431-441. », ou encore par une fonction de modélisation d'un logiciel d'analyse de données équivalente à la fonction « Spline » du logiciel Matlab.

On décrit ci-après une variante préférentielle de l'étape de calcul 2071b comportant les sous-étapes successives suivantes. Afin de réduire le nombre de paramètres à déterminer pour le calcul d'ajustement paramétrique, le calcul 2071b comporte une première sous-étape de translation du signal logarithmique SF mesurée de manière à centrer le point d'inflexion PFL sur les coordonnées d'origine du repère de calcul (0,0). Cette étape présente l'avantage de réduire le nombre à calculer de paramètres de la fonction de modélisation, ici au nombre de deux.

Une deuxième sous-étape consiste ensuite à calculer les paramètres d'ajustement de la fonction de modélisation g, symétrique par rapport au centre du repère d'étude (par rapport aux coordonnées 0,0) et en forme de S, à partir du signal logarithmique SF translaté. La fonction de modélisation g est à titre d'exemple une des fonctions suivantes :

[Math 16]

$$g : x \rightarrow a * \tanh(b * x)$$

Ou :

[Math 17]

$$g : x \rightarrow a * \mathrm{arcsinh}(b * x)$$

Ou :

[Math 18]

$$g : x \rightarrow a(sigmf(b * x) - 0{,}5)$$

Où a et b sont les paramètres à ajuster lors de l'étape de calcul 2071b, tanh étant une fonction tangente hyperbolique, arcsinh est une fonction Arcsinus hyperbolique et sigmf est une fonction sigmoïde.

Ensuite, à partir de la fonction de modélisation g obtenue par ajustement paramétrique, une troisième sous-étape consiste à translater la fonction de modélisation g, cette fois de manière à positionner le point d'inflexion de la fonction de modélisation g sur les coordonnées du point d'inflexion mesuré PFL. A partir de la fonction de modélisation g, il est ainsi possible de modéliser le signal logarithmique SF sur un domaine temporel allant de 0 à l'infini et donc d'estimer des valeurs du signal logarithmique SF sur des temps de relaxation de l'accumulateur électrochimique atteignant l'équilibre thermodynamique suffisant.

L'étape de calcul 2072b comporte ensuite le calcul de la tension OCV pour une durée de relaxation paramétrable comprise entre un instant t nul et un instant t à l'infini au moyen du signal logarithmique SF qui a été modélisé à partir de la fonction de modélisation g.

D'autres variantes de l'étape de calcul 2071b sont envisageables. On peut citer par exemple une méthode de calcul consistant à déterminer lors d'une première sous-étape des points finis du signal logarithmique SF qui sont postérieurs à l'instant t1 du point d'inflexion PFL symétriquement par rapport au point d'inflexion. Ensuite, une deuxième étape de calcul consiste à calculer une fonction de modélisation du signal logarithmique sur des instants allant de 0 à l'infini par interpolation-extrapolation des points mesurés (avant t1) et des points calculés symétriquement (après t1). Enfin, le calcul 2072b de la tension à circuit ouvert OCV est exécuté à partir de la fonction de modélisation obtenue par interpolation-extrapolation pour un instants t paramétrables.

Par ailleurs, selon procédé de détermination de la tension OCV, représenté en figure 3a et 3b, la mesure du signal de tension Uacc(t) se déroule tant que le courant aux bornes de l'accumulateur est nul conformément aux étapes 205 et 208. Dans certaines situations, il a été observé que l'unité de commande a détecté deux points d'inflexion du signal logarithmique ou plus. Ce phénomène s'explique du fait que le graphite lithié d'un accumulateur peut présenter jusqu'à six phases. De plus, sous courant, la dispersion des taux d'insertion des ions lithium dans la matière active (graphite) peut générer la coexistence de plusieurs phases, puis au cours de la relaxation, une compétition de germination entre ces différentes phases est mise en jeu.

Le signal logarithmique, modélisé par la fonction de tangente hyperbolique, est une caractéristique des phénomènes de transitions de phase mis en jeu lors de la relaxation. Grâce au procédé, l'unité de commande est apte à détecter les points d'inflexion caractérisant chacune des transitions de phase (tant que le courant aux bornes de l'accumulateur est nul) et met à jour le calcul de la tension OCV en fonction du dernier point d'inflexion détecté.

En cas de détection d'un nombre impair n de points d'inflexion, conformément à l'étape d'estimation 207a de la tension OCV du premier mode de réalisation du procédé, à l'étape 2071a l'unité de commande calcule l'écart DL du signal logarithmique entre la valeur du dernier point d'inflexion n et la valeur du point d'inflexion n-1 dudit signal logarithmique. Conformément à l'étape d'estimation 207b du deuxième mode de réalisation, l'étape 2071b calcule la fonction de modélisation logarithmique du signal de tension en fonction des valeurs du signal logarithmique à partir de l'instant de détection du point d'inflexion n-1 symétriquement par rapport au dernier point d'inflexion n.

En cas de détection d'un nombre pair j de points d'inflexion, conformément à l'étape d'estimation 207a de la tension OCV du premier mode de réalisation du procédé, l'étape 2071a calcule l'écart DL du signal logarithmique entre la valeur du dernier point d'inflexion j et la valeur du signal logarithmique à l'instant t0 du début de la phase de relaxation. Conformément à l'étape d'estimation 207b du deuxième mode de réalisation, l'étape 2071b calcule une modélisation logarithmique du signal de tension en fonction des valeurs du signal logarithmique à partir de l'instant t0 de début de la phase logarithmique symétriquement par rapport au dernier point d'inflexion j.

Le procédé a été appliqué sur une technologie de cellule électrochimique de type Li-ion et pour différents états de charge et différents états de vieillissement allant respectivement de 20 à 80% d'état de charge et 60% à 100% de l'état de vieillissement. Les points d'inflexion du signal logarithmique ont été observés pour des durées comprise entre 19s et environ 300s après le début d'une phase de relaxation d'une cellule. Ces durées permettent de déterminer la tension à circuit ouvert OCV pour les usages en roulage d'un véhicule sans atteindre l'équilibre thermodynamique. Grâce à de telles performances, le procédé est donc exécutable par le système de gestion d'une batterie de véhicule pour maintenir à jour les indicateurs d'état avec une précision améliorée. Par ailleurs, le procédé requière peu de ressources de calculs. Ce dernier avantage permet d'embarquer la solution pour de nombreuses applications contraintes en consommation et ressources de calcul. On ajoutera finalement que le procédé a été appliqué et validé pour d'autres technologies, telles les technologies Lithium fer phosphate ou Lithium oxyde de manganèse.

**Revendications**

1. Procédé de détermination d'un paramètre de tension à circuit ouvert (OCV) d'une batterie électrochimique (10) d'un système de batterie (100), le procédé étant exécuté par une unité de commande (20) du système (100) durant une phase de relaxation de la batterie (10) et comportant les étapes suivantes :

   - la mesure (202) en continu d'un signal de tension, Uacc(t), aux bornes de la batterie en relaxation en fonction du temps écoulé à partir d'un premier instant (t0) de début de la phase de relaxation,
   - l'estimation (207a ; 207b) du paramètre de tension à circuit ouvert (OCV) dépendant dudit signal de tension mesuré,
   ledit procédé étant **caractérisé en ce qu'**il comporte en outre:

- le calcul (203) en continu durant la relaxation de la batterie (10) d'un signal logarithmique (SF) de la tension dépendant dudit signal de tension Uacc(t) en fonction de la valeur sous forme logarithmique du temps écoulé à partir du premier instant (t0),
- la vérification (205) si le signal logarithmique (SF) comporte un point d'inflexion (PFL),
- et, en cas de détection d'au moins un point d'inflexion (PFL) à un deuxième instant (t1), l'estimation (207a ;207b) consiste à calculer le paramètre de tension à circuit ouvert (OCV) symétriquement par rapport au point d'inflexion (PFL) en fonction au moins de la valeur (U2) du signal logarithmique (SF) au deuxième instant (t1).

2. Procédé selon la revendication 1, **caractérisé en ce que** le signal logarithmique (SF) est une première représentation f1 dudit signal de tension Uacc(t) en fonction de la valeur du temps sous forme logarithmique, où :

[Math 19]

$$f1: \log(t) \rightarrow Uacc(t)$$

3. Procédé selon la revendication 1, **caractérisé en ce que** le signal logarithmique (SF) est une deuxième représentation f2 dudit signal de tension Uacc(t) sous une première forme logarithmique en fonction de la valeur du temps sous forme logarithmique, où

[Math 20]

$$f2: \log(t) \rightarrow \log(Uacc(t))$$

4. Procédé selon la revendication 1, **caractérisé en ce que** le signal logarithmique (SF) est une troisième représentation f3 dudit signal de tension Uacc(t) sous une deuxième forme logarithmique en fonction de la valeur du temps sous forme logarithmique, où

[Math 21]

$$f3: \log(t) \rightarrow \log(\log(Uacc(t)))$$

5. Procédé selon l'une quelconque des revendications 1 à 4, **caractérisé en ce que** l'estimation (207a) comporte les étapes suivantes :

- une étape de calcul (2071a) d'un écart (DL) entre la valeur (U2) du point d'inflexion (PFL) du signal logarithmique (SF) au deuxième instant (t1) et la valeur (U1) du signal logarithmique (SF) au premier instant (t0),
- une étape de calcul (2072a) du paramètre de tension à circuit ouvert (OCV) symétriquement par rapport au point d'inflexion (PFL) du signal logarithmique (SF) au deuxième instant (t1) en fonction dudit écart (DL) et de la valeur (U2) du point d'inflexion (PFL).

6. Procédé selon l'une quelconque des revendications 1 à 4, **caractérisé en ce que** l'estimation (207b) comporte les étapes suivantes :

- une étape de calcul (2071b) d'une modélisation logarithmique (MSF) du signal de tension pour des instants postérieurs au deuxième instant (t1) du point d'inflexion (PFL) en fonction du signal logarithmique (SF) symétriquement par rapport au point d'inflexion (PFL),
- une étape de calcul (2072b) du paramètre de tension à circuit ouvert (OCV) en fonction de la valeur de ladite modélisation (MSF) à un instant recherché postérieur au deuxième instant (t1).

7. Procédé selon la revendication 6, **caractérisé en ce que** le calcul (2071b) de la modélisation logarithmique (MSF) consiste à ajuster les paramètres d'une fonction de modélisation à partir au moins des valeurs du signal logarithmique (SF) mesurées jusqu'au deuxième instant (t1).

8. Procédé selon la revendication 7, **caractérisé en ce que** la fonction de modélisation est une fonction g selon l'une quelconque des relations suivantes :

[Math 22]

$$g: x \to a * \tanh(b * x)$$

ou

[Math 23]

$$g: x \to a * \mathrm{arcsinh}(b * x)$$

,ou

[Math 24]

$$g: x \to a * sigmf(b * x) - 0{,}5,$$

Où a et b sont des paramètres ajustés.

9. Unité de commande d'un système de batterie comportant une batterie électrochimique, **caractérisée en ce qu'**elle comporte des moyens de mettre en œuvre le procédé selon l'une quelconque des revendications 1 à 8.

10. Véhicule automobile comprenant un système de batterie comportant une unité de commande selon la revendication 9.

**Patentansprüche**

1. Verfahren zum Bestimmen eines Leerlaufspannung (OCV) Parameters einer elektrochemischen Batterie (10) eines Batteriesystems (100), wobei das Verfahren von einer Steuerung (20) des Systems (100) während einer Entspannungsphase der Batterie durchgeführt wird (10) und die folgenden Schritte umfasst

   - die kontinuierliche Messung (202) eines Spannungssignals Uacc(t) an den Klemmen der Batterie in Relaxation als Funktion der seit einem ersten Zeitpunkt (t0) des Beginns der Relaxationsphase verstrichenen Zeit,
   - die Schätzung (207a; 207b) des Parameters der Leerlaufspannung (OCV) in Abhängigkeit von dem gemessenen Spannungssignal,
   dass es ferner umfasst
   - kontinuierliches Berechnen (203) während der Entspannung der Batterie (10) eines logarithmischen Signals (SF) der Spannung in Abhängigkeit von dem Spannungssignal Uacc(t) als Funktion des Werts in logarithmischer Form der verstrichenen Zeit von der erste Moment (t0),
   - die Überprüfung (205), ob das logarithmische Signal (SF) einen Wendepunkt (PFL) aufweist,
   - und im Falle der Erfassung mindestens eines Wendepunkts (PFL) zu einem zweiten Zeitpunkt (t1) die Schätzung (207a; 207b) darin besteht, den Leerlaufspannungsparameter (OCV) symmetrisch zu diesem Punkt zu berechnen des Wendepunkts (PFL) als Funktion mindestens des Werts (U2) des logarithmischen Signals (SF) zum zweiten Zeitpunkt (t1).

2. Verfahren nach Anspruch 1, **dadurch gekennzeichnet, dass** das logarithmische Signal (SF) eine erste Darstellung f1 des Spannungssignals Uacc(t) als Funktion des Zeitwerts in logarithmischer Form ist, wobei

[ Mathe 19]

$$f1: \log(t) \rightarrow Uacc(t)$$

**3.** Verfahren nach Anspruch 1, **dadurch gekennzeichnet, dass** das logarithmische Signal (SF) eine zweite Darstellung f2 des Spannungssignals Uacc(t) in einer ersten logarithmischen Form als Funktion des Zeitwerts in logarithmischer Form ist, wobei

[Mathe 20]

$$f2: \log(t) \rightarrow \log(Uacc(t))$$

**4.** Verfahren nach Anspruch 1, **dadurch gekennzeichnet, dass** das logarithmische Signal (SF) eine dritte Darstellung f3 des Spannungssignals Uacc(t) in einer zweiten logarithmischen Form als Funktion des Zeitwerts in logarithmischer Form ist, wobei

[Mathe 21]

$$f3: \log(t) \rightarrow \log(\log(Uacc(t)))$$

**5.** Verfahren nach einem der Ansprüche 1 bis 4, **dadurch gekennzeichnet, dass** die Schätzung (207a) die folgenden Schritte umfasst

- einen Schritt zum Berechnen (2071a) einer Differenz (DL) zwischen dem Wert (U2) des Wendepunkts (PFL) des logarithmischen Signals (SF) zum zweiten Zeitpunkt (t1) und dem Wert (U1) des logarithmischen Signals (SF) zum ersten Zeitpunkt (t0),
- einen Schritt zum Berechnen (2072a) des Leerlaufspannungsparameters (OCV) symmetrisch in Bezug auf den Wendepunkt (PFL) des logarithmischen Signals (SF) zum zweiten Zeitpunkt (t1) als Funktion der Abweichung (DL). und des Werts (U2) des Wendepunkts (PFL).

**6.** Verfahren nach einem der Ansprüche 1 bis 4, **dadurch gekennzeichnet, dass** die Schätzung (207b) die folgenden Schritte umfasst

- einen Berechnungsschritt (2071b) einer logarithmischen Modellierung (MSF) des Spannungssignals für Zeitpunkte nach dem zweiten Zeitpunkt (t1) des Wendepunkts (PFL) als Funktion des logarithmischen Signals (SF) symmetrisch zu dem Wendepunkt (PFL),
- einen Berechnungsschritt (2072b) des Leerlaufspannungsparameters (OCV) als Funktion des Werts der Modellierung (MSF) zu einem gewünschten Zeitpunkt nach dem zweiten Zeitpunkt (t1).

**7.** Verfahren nach Anspruch 6, **dadurch gekennzeichnet, dass** die Berechnung (2071b) der logarithmischen Modellierung (MSF) darin besteht, die Parameter einer Modellierungsfunktion aus mindestens den bis zum zweiten Zeitpunkt gemessenen Werten des logarithmischen Signals (SF) einzustellen (t1).

**8.** Verfahren nach Anspruch 7, **dadurch gekennzeichnet, dass** die Modellierungsfunktion eine Funktion g gemäß einer der folgenden Beziehungen ist

[Mathe 22]

$$g: x \rightarrow a * \tanh(b * x),$$

*ou*

[Mathe 23]

$$g: x \rightarrow a * \mathrm{arcsinh}(b * x),$$

ou

[Mathe 24]

$$g: x \rightarrow a * sigmf(b * x) - 0,5,$$

wobei a und b angepasste Parameter sind.

9.  Steuereinheit eines Batteriesystems mit einer elektrochemischen Batterie, **dadurch gekennzeichnet, dass** sie Mittel zur Durchführung des Verfahrens nach einem der Ansprüche 1 bis 8 umfasst.

10. Kraftfahrzeug umfassend ein Batteriesystem umfassend eine Steuereinheit nach Anspruch 9.

**Claims**

1.  Method of determining an open circuit voltage (OCV) parameter of an electrochemical battery (10) of a battery system (100), the method being performed by a controller (20) of the system (100) during a relaxation phase of the battery (10) and comprising the following steps

    - the continuous measurement (202) of a voltage signal, Uacc(t), at the terminals of the battery in relaxation as a function of the time elapsed from a first instant (t0) of the start of the relaxation phase,
    - the estimation (207a; 207b) of the open circuit voltage (OCV) parameter depending on said measured voltage signal,
    said method being **characterized in that** it further comprises:

    - the calculation (203) continuously during the relaxation of the battery (10) of a logarithmic signal (SF) of the voltage depending on said voltage signal Uacc(t) as a function of the value in logarithmic form of the time elapsed from of the first moment (t0),
    - the verification (205) whether the logarithmic signal (SF) comprises a point of inflection (PFL),
    - and, in the event of detection of at least one point of inflection (PFL) at a second instant (t1), the estimation (207a; 207b) consists in calculating the open circuit voltage parameter (OCV) symmetrically by relative to the point of inflection (PFL) as a function at least of the value (U2) of the logarithmic signal (SF) at the second instant (t1).

2.  Method according to claim 1, **characterized in that** the logarithmic signal (SF) is a first representation f1 of said voltage signal Uacc(t) as a function of the value of time in logarithmic form, where

[ Math 19]

$$f1: \log(t) \rightarrow Uacc(t)$$

3.  Method according to claim 1, **characterized in that** the logarithmic signal (SF) is a second representation f2 of said voltage signal Uacc(t) in a first logarithmic form as a function of the value of time in logarithmic form, where

[Math 20]

$$f2: \log(t) \rightarrow \log(Uacc(t))$$

4.  Method according to claim 1, **characterized in that** the logarithmic signal (SF) is a third representation f3 of said voltage signal Uacc(t) in a second logarithmic form as a function of the value of time in logarithmic form, where

[Math 21]

$$f3: \log(t) \rightarrow \log\left(\log\left(Uacc(t)\right)\right)$$

5. Method according to any one of claims 1 to 4, **characterized in that** the estimation (207a) comprises the following steps

   - a step of calculating (2071a) a difference (DL) between the value (U2) of the inflection point (PFL) of the logarithmic signal (SF) at the second instant (t1) and the value (U1) of the logarithmic signal (SF) at the first instant (t0),
   - a step of calculating (2072a) the open circuit voltage parameter (OCV) symmetrically with respect to the inflection point (PFL) of the logarithmic signal (SF) at the second instant (t1) as a function of said difference (DL) and the value (U2) of the inflection point (PFL).

6. Method according to any one of claims 1 to 4, **characterized in that** the estimation (207b) comprises the following steps

   - a calculation step (2071b) of a logarithmic modeling (MSF) of the voltage signal for instants subsequent to the second instant (t1) of the inflection point (PFL) as a function of the logarithmic signal (SF) symmetrically with respect to the point of inflection (PFL),
   - a calculation step (2072b) of the open-circuit voltage parameter (OCV) as a function of the value of said modeling (MSF) at a desired instant subsequent to the second instant (t1).

7. Method according to claim 6, **characterized in that** the calculation (2071b) of the logarithmic modeling (MSF) consists in adjusting the parameters of a modeling function from at least the values of the logarithmic signal (SF) measured up to the second instant (t1).

8. Method according to claim 7, **characterized in that** the modeling function is a function g according to any one of the following relationships

[Math 22]

$$g: x \rightarrow a * \tanh(b * x), ou$$

[Math 23]

$$g: x \rightarrow a * \operatorname{arcsinh}(b * x), ou$$

[Math 24]

$$g: x \rightarrow a * sigmf(b * x) - 0{,}5,$$

where a and b are fitted parameters.

9. Control unit of a battery system comprising an electrochemical battery, **characterized in that** it comprises means for implementing the method according to any one of claims 1 to 8.

10. Motor vehicle comprising a battery system comprising a control unit according to claim 9.

[Fig. 1]

[Fig. 2]

[Fig. 3a]

[Fig. 3b]

[Fig. 4]

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3044773 A1
- WO 02091007 A1
- WO 2008053410 A2

**Littérature non-brevet citée dans la description**

- **LAGARIAS, J. C. ; J. A. REEDS ; M. H. WRIGHT ; P. E. WRIGHT.** Convergence Properties of the Nelder-Mead Simplex Method in Low Dimensions. *SIAM Journal of Optimization.,* 1998, vol. 9 (1), 112-147
- **MARQUARDT, D.** An Algorithm for Least-squares Estimation of Nonlinear Parameters. *SIAM Journal Applied Mathematics,* 1963, vol. 11, 431-441